(19) Europäisches Patentamt / European Patent Office / Office européen des brevets

(11) **EP 3 339 469 A1**

(12) **EUROPEAN PATENT APPLICATION**
published in accordance with Art. 153(4) EPC

(43) Date of publication:
**27.06.2018 Bulletin 2018/26**

(21) Application number: **17770341.0**

(22) Date of filing: **23.03.2017**

(51) Int Cl.:
*C23C 14/34* (2006.01)      *C22C 14/00* (2006.01)
*C22C 27/02* (2006.01)

(86) International application number:
**PCT/JP2017/011695**

(87) International publication number:
**WO 2017/164301 (28.09.2017 Gazette 2017/39)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **25.03.2016 JP 2016062544**

(71) Applicant: **JX Nippon Mining & Metals Corporation Tokyo 100-8164 (JP)**

(72) Inventors:
• **ODA Kunihiro**
  **Kitaibaraki-shi**
  **Ibaraki 319-1535 (JP)**
• **MIYATA Chisaka**
  **Kitaibaraki-shi**
  **Ibaraki 319-1535 (JP)**

(74) Representative: **Cornford, James Robert**
**Forresters IP LLP**
**Skygarden**
**Erika-Mann-Strasse 11**
**80636 München (DE)**

(54) **Ti-Ta ALLOY SPUTTERING TARGET AND PRODUCTION METHOD THEREFOR**

(57) A Ti-Ta alloy sputtering target containing 0.1 to 30 at% of Ta, and remainder being Ti and unavoidable impurities, wherein the Ti-Ta alloy sputtering target has an oxygen content of 400 wtppm or less. The present invention has a favorable surface texture with a low oxygen content and is readily processable due to its low hardness, and therefore the present invention yields a superior effect of being able to suppress the generation of particles during sputtering.

[Fig. 1]

Outer periphery of target
10mm
r/2
r/2
10mm
10mm
10mm
r/2
r/2
10mm
● Points of observation

EP 3 339 469 A1

**Description**

TECHNICAL FIELD

The present invention relates to a Ti-Ta alloy sputtering target suitable for forming a barrier layer in the wiring of a semiconductor integrated circuit and to the production method thereof, and in particular relates to a Ti-Ta alloy sputtering target prepared via melting and to the production method thereof.

BACKGROUND ART

There is a sign of slowdown in miniaturization of the width of interconnecting wires in a large-scale integrated circuit (LSI), but high integration by the miniaturization, and low power consumption are still being demanded, and such trend continues today along with the advancement of vapor deposition techniques such as the physical vapor deposition method.

Meanwhile, materials configuring the circuit elements have not undergone any major technological innovation, and have been undergoing repeated minor modifications; for example, the addition of one or more alloy elements to a main material. The Cu wiring and Ta diffusion barrier materials that were introduced around 2000 are still prevalent today. Moreover, Ti, Ni alloy, W and the like are still being used as the main materials around the gate electrode. Among the above, Ti has a long history of being used as a material configuring LSI, and has also been used as a diffusion barrier material for Al wiring, as a salicide material of gate electrodes, or as a metal gate material in various parts.

Because the raw material of Ta is expensive, the use of Ta as a barrier material for Cu wiring results in increased production costs, and the use of Nb, which is relatively inexpensive, and Ti, which has a track record of being used as a barrier material for Al wiring, as alternative materials are being invariably considered. Nevertheless, under circumstances where the micro wiring is being advanced and the required characteristics are becoming stricter, the current situation is that characteristics that surpass Ta have not yet been achieved.

However, in recent years, the trend of using a Co material as the Cu wiring liner material is accelerating, and a Ta material, which is used together in a pair with the foregoing material, may become shifted to another material. Furthermore, a pure Ti material for use in a metal gate is also demanded of heat resistance pursuant to the thinning of interconnecting wires, and the opportunity of adding alloys is increasing as was the case in a shift from Ni to NiPt. Al and Nb are recognized, on a practical and experimental level, as the alloy elements to be added to Ti, and Ta, of which use had been considered at a relatively early stage, is also contemplated once again as an alloy element.

Conventionally, because of the high melting point of Ta, it was difficult to obtain a Ti-Ta alloy via melting, plastic working of the obtained alloy ingot was difficult due to its high degree of hardness, and a Ti-Ta alloy was generally prepared via powder metallurgy. Nevertheless, while molding based on powder metallurgy is easy, the oxygen content is high due to a large surface area of the raw material, and there are often problems with the quality of the film deposited via the sputtering method. Thus, mass production of the Ti-Ta alloy has not yet been realized to date.

Conventional technologies related to a Ti alloy as a diffusion barrier layer for use in LSI are presented below. Patent Documents 1 to 3 disclose forming a barrier film formed from a titanium alloy between an insulating film and a conductive layer (wire). Moreover, Patent Documents 4 to 6 disclose a Ti alloy sputtering target.

Nevertheless, Patent Documents 4 and 6 are related to targets obtained via powder metallurgy, and entail the problem of characteristic degradation caused by the oxygen content described above. Patent Document 5 discloses a Ti-Ta alloy sputtering target prepared via melting/casting, but this technology merely suggests melting Ta having an ultrahigh melting point and a Ti material, which has a melting point difference of nearly 1500°C in comparison to Ta, via vacuum skull melting, has no recognition concerning the problems related to the uniformity of melting or the problems related to the oxygen content based on the selection of raw materials, and offers no description regarding the characteristic improvement of the target.

[CITATION LIST]

[PATENT DOCUMENTS]

[Patent Document 1] JP 2001-110751 A
[Patent Document 2] JP 2008-098284 A
[Patent Document 3] JP 2010-123586 A
[Patent Document 4] JP H01-290766 A
[Patent Document 5] JP 2004-506814 A

[Patent Document 6] JP 5701879 B

SUMMARY OF INVENTION

[TECHNICAL PROBLEM]

An object of the present invention is to provide a Ti-Ta alloy sputtering target capable of suppressing the generation of particles during sputtering. In particular, an object of the present invention is to provide a Ti-Ta alloy sputtering target capable of lowering the Vickers hardness and reducing the generation of particles during sputtering, which is caused by oxygen, as a result of reducing the oxygen concentration in the target, and the production method thereof.

[SOLUTION TO PROBLEM]

The present inventors discovered that the oxygen concentration can be lowered and a low-hardness Ti-Ta alloy can be prepared by properly adjusting the raw material shape and the melting conditions. Based on the foregoing discovery, the present application provides the following invention.

1) A Ti-Ta alloy sputtering target containing 0.1 to 30 at% of Ta, and remainder being Ti and unavoidable impurities, wherein the Ti-Ta alloy sputtering target has an oxygen content of 400 wtppm or less.
2) The Ti-Ta alloy sputtering target according to 1) above, wherein a variation in the oxygen content is within 20%.
3) The Ti-Ta alloy sputtering target according to 1) or 2) above, wherein the Ti-Ta alloy sputtering target has a Vickers hardness of 400 Hv or less.
4) The Ti-Ta alloy sputtering target according to 3) above, wherein a variation in the Vickers hardness is within 10%.
5) The Ti-Ta alloy sputtering target according to any one of 1) to 4) above, wherein the Ti-Ta alloy sputtering target has a surface roughness Ra of 1.0 $\mu$m or less.
6) The Ti-Ta alloy sputtering target according to any one of 1) to 5) above, wherein the Ti-Ta alloy sputtering target has a purity of 4N or higher.
7) The Ti-Ta alloy sputtering target according to any one of 1) to 6) above, wherein the Ti-Ta alloy sputtering target has a relative density of 99.9% or higher.
8) A method of producing a Ti-Ta alloy sputtering target, the method comprising: preparing a Ti material having a thickness of 1 mm or more and 5 mm or less and an equal side length of 10 mm or more and 50 mm or less, and a Ta material having a thickness of 0.5 mm or more and 2 mm or less and a width of 2 mm or more and 50 mm or less; placing the Ti material in a vacuum melting furnace; after being melted, adding the Ta material thereto in order to alloy Ti-Ta; casing a resulting molten alloy in a crucible to prepare an ingot; and subjecting an obtained Ti-Ta alloy ingot to plastic working to form a target shape.
9) The method of producing a Ti-Ta alloy sputtering target according to 8) above, comprising: placing the Ti material in the vacuum melting furnace; and after being melted, adding the Ta material thereto in multiple batches.

[ADVANTAGEOUS EFFECTS OF INVENTION]

The present invention is able to reduce the hardness of a Ti-Ta sputtering target prepared via melting/casting and reduce the generation of particles during sputtering, which is caused by oxygen, as a result of reducing the oxygen concentration in the target. Moreover, because the reduction of hardness improves the workability and machinability of the target and enables the realization of a favorable surface texture, the present invention yields a superior effect of being able to suppress abnormal discharge caused by the processing marks on the target surface.

BRIEF DESCRIPTION OF DRAWINGS

[Fig. 1] This is a diagram showing the measurement points of the sputtering target for respective measurements.
[Fig. 2] This is a diagram showing the points at which the purity of the sputtering target is measured.

DESCRIPTION OF EMBODIMENTS

The present invention is a Ti-Ta alloy sputtering target prepared via melting/casting, and the constituents thereof are 0.1 to 30 at% of Ta, and remainder being Ti and unavoidable impurities. In the sputtering target of the present invention, when the Ta content is less than 0.1 at%, the effect of improving the film properties (adhesiveness, heat resistance) of the Ti film cannot be attained. Meanwhile, when the Ta content exceeds 30 at%, an unmelted residue of Ta will remain during the melting process, and it is difficult to achieve the uniform properties of the material. Thus, the Ta content is set to be within the foregoing range.

Because the sputtering target of the present invention is prepared via melting/casting, not only is it possible to reduce the oxygen content in comparison to the powder sintering method, the present invention is able to further reduce the amount of oxygen; specifically, the present invention is able to achieve an oxygen content of 400 wtppm or less, by adjusting the raw material shape. It is thereby possible to lower the hardness of the target, and effectively suppress the generation of particles during sputtering caused by oxygen.

Moreover, the present invention can cause the variation in the foregoing oxygen content to be within 20%. When the variation in the oxygen concentration exceeds 20%, this is undesirable since the target in-plane hardness will also become varied and a uniform surface texture cannot be obtained. In order to inhibit the variation in the oxygen content, it is necessary to make the input material of Ta (melting point: 3020°C), which is a high melting point metallic material, into small pieces to the extent possible, but when the raw material is made too small, the amount of oxygen that becomes adsorbed on the surface will increase. Thus, the size adjustment of the input material is extremely important. The present invention resolves the contradictory problems of oxygen content and its variation by strictly controlling the size of the input material as described later.

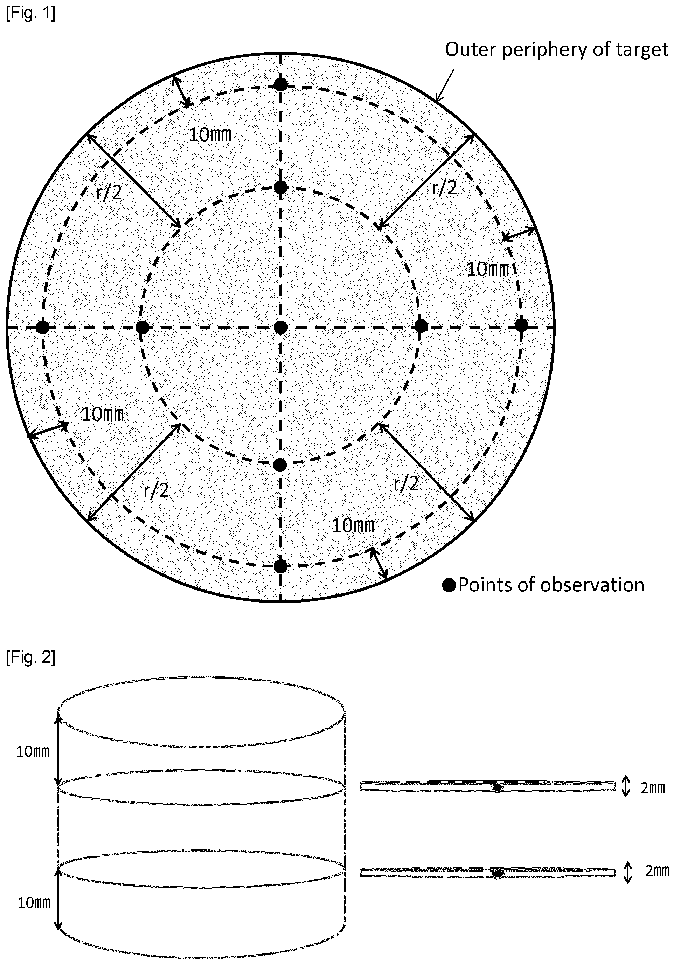

In the present invention, the oxygen content in the respective pieces (0.5 to 1 g), which were sampled from 9 in-plane points of the target (the center, and on 2 diameter lines perpendicular to one another, 4 points positioned at 1/2 the radius, and 4 points positioned 10 mm inward from the outer periphery of the target) as shown in Fig. 1, was measured based on the LECO method. Subsequently, the variation in the oxygen content was calculated based on the following formula.

$$\text{Formula: Variation (\%) in oxygen content} = \text{(maximum value - minimum value) / average value} \times 100$$

The Ti-Ta alloy sputtering target of the present invention preferably has a Vickers hardness of 400 Hv or less, more preferably 300 Hv or less, and most preferably 200 Hv or less. As the Vickers hardness is lower, plastic working and cutting work can be facilitated, and the target can be processed into a favorable final shape. And a favorable surface texture yields a superior effect of being able to suppress the generation of arcing during sputtering.

Because the hardness of a metal or an alloy normally becomes lower as the purity becomes higher, considered may be improving the refining capacity and reducing the amount of impurities in order to obtain a low-hardness material. Nevertheless, in the foregoing case, there is a problem in that an additional refining process is required and it causes an increase in the production cost. Moreover, oxygen is a gas component and, unlike metal impurities, there is a limit in the reduction thereof based on a normal refining process. The present invention focused on the oxygen in the target (raw material), and realizes a low-hardness target by reducing the oxygen concentration as much as possible, even when the target (raw material) has a purity of 4N to 5N.

The in-plane variation in the Vickers hardness of the foregoing Ti-Ta alloy sputtering target is preferably within 10%. When the in-plane variation in the Vickers hardness exceeds 10%, the surface texture may change depending on the measurement points, and uniform deposition may become difficult. The variation in the Vickers hardness was measured as follows. Specifically, the hardness of the respective pieces (5 to 10 g), which were sampled from 9 in-plane points of the target (the center, and on 2 diameter lines perpendicular to one another, 4 points positioned at 1/2 the radius, and 4 points positioned 10 mm inward from the outer periphery of the target) as shown in Fig. 1, was measured based on the Vickers hardness measurement method of JIS Z 2244. Subsequently, the variation in the hardness was calculated based on the following formula.

$$\text{Formula: Variation (\%) in Vickers hardness} = \text{(maximum value - minimum value) / average value} \times 100$$

Moreover, in the present invention, the surface roughness Ra of the sputtering target is preferably 1.0 $\mu$m or less. As described above, because the present invention is able to lower the hardness of the Ti-Ta alloy target, cutting work can be easily performed to the target, and it is thereby possible to prepare a target with a superior surface texture having a surface roughness Ra of 1.0 $\mu$m or less. It is thereby possible to improve the deposition properties.

The surface roughness was respectively measured based on the surface texture measurement method of JIS B 0601 at 9 in-plane points of the target (the center, and on 2 diameter lines perpendicular to one another, 4 points positioned at 1/2 the radius, and 4 points positioned 10 mm inward from the outer periphery of the target) as shown in Fig. 1, and averaged to obtain the surface roughness of the present invention.

In the present invention, the purity is preferably 4N (99.99%) or higher and 5N (99.999%) or less. Here, a purity of 4N means that the total value of Na, Al, Si, K, Cr, Mn, Fe, Co, Ni, Cu, Zn, and Zr analyzed via the glow-discharge mass spectrometry (GDMS) is less than 100 ppm. Because the purity and hardness of a Ti-Ta alloy are of a proportional relation, the hardness can be lowered by increasing the purity, and, when impurities are contained in a large amount, there are cases where a quality of the film becomes deteriorated and the intended film properties cannot be obtained. In the present invention, the purity was measured as follows. Specifically, as shown in Fig. 2, disk-shaped samples were prepared by cutting out slices having a thickness of 2 mm from the ingot (target material) at 10 mm inward from the top face or the bottom face of the ingot, pieces (2 mm × 2 mm × 15 mm) were removed from the center of the foregoing samples, and analyzed via GDMS to measure the foregoing impurity content.

Because the Ti-Ta alloy sputtering target of the present invention is prepared via casting, the density becomes higher in comparison to a case of preparing a target by sintering a powder. The relative density of a sintered compact (target material) prepared by sintering a powder is roughly 97%, but in the present invention, it is possible to achieve a relative density of 99.9% or higher. This kind of high-density target can contribute to the suppression of particles. The term "relative density" as used in the present invention refers to the ratio of the measured (evaluated) density of Ti-Ta, which is evaluated based on the Archimedes method, relative to the theoretical density of Ti-Ta, as expressed in the following formula.

$$\text{Formula: Relative density (\%)} = (\text{Archimedes density / theoretical density}) \times 100$$

Here, the theoretical density of Ti-Ta is expressed based on the following formula when the ratio of Ta atoms in the target is N (%).

$$\text{Formula: Theoretical density (g/cm}^3) = (4787 - 133.1 \times N) / (1061 - 0.254 \times N)$$

The Ti-Ta alloy sputtering target of the present invention can be produced based on the following method. Foremost, a Ti raw material having a purity of 4N or higher and a Ta raw material having a purity of 4N or higher are prepared in an amount to attain the intended atomic ratio. Here, the oxygen concentration will increase when the surface area of the raw materials is large, and therefore it is desirable to use raw materials that have a small surface area. In particular, the Ti material is preferably formed in a tile-like shape having a thickness of 1 mm or more and 5 mm or less and an equal side length of 10 mm or more and 50 mm or less, and the Ta material is preferably formed in a plate shape or a ribbon shape having a thickness of 0.5 mm or more and 2 mm or less, a width of 2 mm or more and 50 mm or less, and a length to be suitably decided. Raw materials having the foregoing shapes can be prepared by regulating the size of mill ends prepared by cutting and grinding the respective metal ingots. Subsequently, in order to remove contamination, the raw materials are washed, degreased and, as needed, pickled.

Subsequently, the raw materials are placed in a vacuum skull melting furnace comprising a water-cooled copper crucible of cp150 mm × 200 mmL to be subject to melting. After confirming that only the Ti raw material has melted, the Ta raw material is added thereto in multiple batches. This is because: melting is possible even when the Ta raw material is simultaneously placed together with the Ti material when the Ta content is within the range of 0.1 to 3 at%; but when the Ta content is within the range of 3 to 30 at%, the uniformity of the melted material (including the oxygen in the material) can be retained favorably by subsequently adding the Ta material thereto in multiple batches.

It is thereby possible to promote the melting/synthesizing of a low Ta composition and maintain the fluidity of the molten metal at a melting temperature that is considerably lower than the Ta melting point of 3020°C, and the composition can be precisely controlled without any dispersion or volatilization of Ti (melting point: 1668°C) that is exposed to a high temperature near the melting point of Ta.

Next, the molten metal of the Ti-Ta alloy obtained by melting and synthesizing all raw materials prepared in the intended composition is cooled in a water-cooled copper crucible to prepare a Ti-Ta alloy ingot. The prepared ingot is thereafter subject to hot forging at 700 to 1200°C, and then subject to hot rolling at 700 to 1000°C. Note that, subsequently, secondary forging and secondary rolling may also be performed as needed. The present invention is not limited by the foregoing processes, and the number of times and temperature of forging and rolling may be suitably selected for obtaining the intended shape or texture.

Subsequently, the surface of the Ti-Ta alloy that was subject to the foregoing plastic working is machined via cutting and polishing to obtain the intended surface texture. A Ti-Ta alloy sputtering target comprising the characteristics of the present invention can be produced based on the foregoing processes. The thus obtained target can suppress the generation of particles during sputtering, and improve the adhesiveness and heat resistance of the formed film.

[EXAMPLES]

The present invention is now explained with reference to the Examples. Note that these Examples are merely illustrative, and the present invention shall in no way be limited thereby. In other words, various modifications and other embodiments are covered by the present invention, and the present invention is limited only by the scope of its claims.

(Example 1)

A Ti raw material (purity of 4N or higher) having an equal side length of 30 mm and a thickness of 2 mm and a ribbon-shaped Ta raw material (purity of 4N or higher) having a width of 10 mm, a length of 50 mm, and a thickness of 1 mm were prepared, and these materials were weighed to attain a Ti content of 99.9 at% and a Ta content of 0.1 at%, and then placed in a melting furnace. Subsequently, vacuum skull melting was performed at a power output that the Ti material would melt to obtain a Ti-Ta alloy, and the resulting molten alloy was cooled in a water-cooled copper crucible. Subsequently, the Ti-Ta alloy ingot was subject to hot forging at 700°C, and thereafter subject to hot rolling at 700°C. The Ti-Ta alloy that was subject to the foregoing plastic working was thereafter machined via cutting and polishing to obtain the intended surface texture.

The oxygen content, relative density, Vickers hardness, and surface roughness of the sputtering target obtained with the foregoing processes were examined. Consequently, the oxygen content was 350 wtppm (variation: 18%), the relative density was 100%, the Vickers hardness was 150 Hv (variation: 10%), and the surface roughness Ra was 0.4 $\mu$m. The thus obtained target was mounted in sputtering equipment to perform sputtering. The sputtering conditions were as follows; namely, input power of 15 kw and Ar gas flow of 8 sccm, and, after performing pre-sputtering at 75 kWhr, film deposition onto a silicon substrate having a 12-inch diameter was performed for 15 seconds. The number of particles having a size of 0.1 $\mu$m or larger that adhered to the substrate was 3 particles. Moreover, as a result of subjecting the formed film to a heat test (heating at 700°C), peeling and other defects could not be observed, and the film exhibited favorable adhesiveness and heat resistance.

(Example 2)

A Ti raw material (purity of 4N or higher) having an equal side length of 30 mm and a thickness of 2 mm and a ribbon-shaped Ta raw material (purity of 4N or higher) having a width of 10 mm, a length of 50 mm, and a thickness of 1 mm were prepared, and these materials were weighed to attain a Ti content of 98 at% and a Ta content of 2 at%, and then placed in a melting furnace. Subsequently, vacuum skull melting was performed at a power output that the Ti material would melt to obtain a Ti-Ta alloy, and the resulting molten alloy was cooled in a water-cooled copper crucible. Subsequently, the Ti-Ta alloy ingot was subject to hot forging at 700°C, and thereafter subject to hot rolling at 700°C. The Ti-Ta alloy that was subject to the foregoing plastic working was thereafter machined via cutting and polishing to obtain the intended surface texture.

The oxygen content, relative density, Vickers hardness, and surface roughness of the sputtering target obtained with the foregoing processes were examined. Consequently, the oxygen content was 320 wtppm (variation: 19%), the relative density was 100%, the Vickers hardness was 170 Hv (variation: 12%), and the surface roughness Ra was 0.5 $\mu$m. The thus obtained target was mounted in sputtering equipment to perform sputtering. The sputtering conditions were as follows; namely, input power of 15 kw and Ar gas flow of 8 sccm, and, after performing pre-sputtering at 75 kWhr, film deposition onto a silicon substrate having a 12-inch diameter was performed for 15 seconds. The number of particles having a size of 0.1 $\mu$m or larger that adhered to the substrate was 3 particles. Moreover, as a result of subjecting the formed film to a heat test (heating at 700°C), peeling and other defects could not be observed, and the film exhibited favorable adhesiveness and heat resistance.

(Example 3)

A Ti raw material (purity of 4N or higher) having an equal side length of 50 mm and a thickness of 5 mm and a ribbon-shaped Ta raw material (purity of 4N or higher) having a width of 10 mm, a length of 50 mm, and a thickness of 1 mm were prepared, and these materials were weighed to attain a Ti content of 97 at% and a Ta content of 3 at%. The Ti material was foremost placed in a melting furnace, and the Ta material was set in a batch charger for supplementary addition in multiple batches. Subsequently, vacuum skull melting was performed at a power output that the Ti material would melt and, after confirming that the Ti raw material has melted, the Ta material was added in 10 batches. The resulting molten alloy was thereafter cooled in a water-cooled copper crucible. Subsequently, the Ti-Ta alloy ingot was subject to hot forging at 1200°C, and thereafter subject to hot rolling at 1000°C. The Ti-Ta alloy that was subject to the foregoing plastic working was thereafter machined via cutting and polishing to obtain the intended surface texture.

The oxygen content, relative density, Vickers hardness, and surface roughness of the sputtering target obtained with the foregoing processes were examined. Consequently, the oxygen content was 310 wtppm (variation: 15%), the relative density was 100%, the Vickers hardness was 180 Hv (variation: 10%), and the surface roughness Ra was 0.5 μm. The thus obtained target was mounted in sputtering equipment to perform sputtering. Note that the sputtering conditions were the same as Example 1. The number of particles having a size of 0.1 μm or larger that adhered to the substrate was 3 particles. Moreover, as a result of subjecting the formed film to a heat test (heating at 700°C), peeling and other defects could not be observed, and the film exhibited favorable adhesiveness and heat resistance.

(Example 4)

A Ti raw material (purity of 4N or higher) having an equal side length of 50 mm and a thickness of 5 mm and a ribbon-shaped Ta raw material (purity of 4N or higher) having a width of 10 mm, a length of 50 mm, and a thickness of 1 mm were prepared, and these materials were weighed to attain a Ti content of 90 at% and a Ta content of 10 at%. The Ti material was foremost placed in a melting furnace, and the Ta material was set in a batch charger for supplementary addition in multiple batches. Subsequently, vacuum skull melting was performed at a power output that the Ti material would melt and, after confirming that the Ti raw material has melted, the Ta material was added in 10 batches. The resulting molten alloy was thereafter cooled in a water-cooled copper crucible. Subsequently, the Ti-Ta alloy ingot was subject to hot forging at 1200°C, and thereafter subject to hot rolling at 1000°C. The Ti-Ta alloy that was subject to the foregoing plastic working was thereafter machined via cutting and polishing to obtain the intended surface texture.

The oxygen content, relative density, Vickers hardness, and surface roughness of the sputtering target obtained with the foregoing processes were examined. Consequently, the oxygen content was 250 wtppm (variation: 13%), the relative density was 100%, the Vickers hardness was 230 Hv (variation: 8%), and the surface roughness Ra was 0.6 μm. The thus obtained target was mounted in sputtering equipment to perform sputtering. Note that the sputtering conditions were the same as Example 1. The number of particles having a size of 0.1 μm or larger that adhered to the substrate was 8 particles. Moreover, as a result of subjecting the formed film to a heat test (heating at 700°C), peeling and other defects could not be observed, and the film exhibited favorable adhesiveness and heat resistance.

(Example 5)

A Ti raw material (purity of 4N or higher) having an equal side length of 50 mm and a thickness of 5 mm and a ribbon-shaped Ta raw material (purity of 4N or higher) having a width of 10 mm, a length of 50 mm, and a thickness of 1 mm were prepared, and these materials were weighed to attain a Ti content of 80 at% and a Ta content of 20 at%. The Ti material was foremost placed in a melting furnace, and the Ta material was set in a batch charger for supplementary addition in multiple batches. Subsequently, vacuum skull melting was performed at a power output that the Ti material would melt and, after confirming that the Ti raw material has melted, the Ta material was added in 10 batches. The resulting molten alloy was thereafter cooled in a water-cooled copper crucible. Subsequently, the Ti-Ta alloy ingot was subject to hot forging at 1200°C, and thereafter subject to hot rolling at 1000°C. The Ti-Ta alloy that was subject to the foregoing plastic working was thereafter machined via cutting and polishing to obtain the intended surface texture.

The oxygen content, relative density, Vickers hardness, and surface roughness of the sputtering target obtained with the foregoing processes were examined. Consequently, the oxygen content was 190 wtppm (variation: 8%), the relative density was 100%, the Vickers hardness was 280 Hv (variation: 9%), and the surface roughness Ra was 0.6 μm. The thus obtained target was mounted in sputtering equipment to perform sputtering. Note that the sputtering conditions were the same as Example 1. The number of particles having a size of 0.1 μm or larger that adhered to the substrate was 5 particles. Moreover, as a result of subjecting the formed film to a heat test (heating at 700°C), peeling and other defects could not be observed, and the film exhibited favorable adhesiveness and heat resistance.

(Example 6)

A Ti raw material (purity of 4N or higher) having an equal side length of 50 mm and a thickness of 5 mm and a ribbon-shaped Ta raw material (purity of 4N or higher) having a width of 10 mm, a length of 50 mm, and a thickness of 1 mm were prepared, and these materials were weighed to attain a Ti content of 70 at% and a Ta content of 30 at%. The Ti material was foremost placed in a melting furnace, and the Ta material was set in a batch charger for supplementary addition in multiple batches. Subsequently, vacuum skull melting was performed at a power output that the Ti material would melt and, after confirming that the Ti raw material has melted, the Ta material was added in 10 batches. The resulting molten alloy was thereafter cooled in a water-cooled copper crucible. Subsequently, the Ti-Ta alloy ingot was subject to hot forging at 1200°C, and thereafter subject to hot rolling at 1000°C. The Ti-Ta alloy that was subject to the foregoing plastic working was thereafter machined via cutting and polishing to obtain the intended surface texture.

The oxygen content, relative density, Vickers hardness, and surface roughness of the sputtering target obtained with the foregoing processes were examined. Consequently, the oxygen content was 150 wtppm (variation: 5%), the relative density was 100%, the Vickers hardness was 380 Hv (variation: 6%), and the surface roughness Ra was 0.8 μm. The thus obtained target was mounted in sputtering equipment to perform sputtering. Note that the sputtering conditions were the same as Example 1. The number of particles having a size of 0.1 μm or larger that adhered to the substrate was 8 particles. Moreover, as a result of subjecting the formed film to a heat test (heating at 700°C), peeling and other defects could not be observed, and the film exhibited favorable adhesiveness and heat resistance.

(Comparative Example 1)

A Ti raw material (purity of 4N or higher) and a Ta raw material (purity of 4N or higher) both having an equal side length of 60 mm and a thickness of 10 mm were prepared, and these materials were weighed to attain a Ti content of 99.9 at% and a Ta content of 0.1 at%. The Ti material was foremost placed in a melting furnace, and the Ta material was set in a batch charger for supplementary addition at once. Subsequently, vacuum skull melting was performed at a power output that the Ti material would melt and, after confirming that the Ti raw material has melted, the square Ta material was added at once. The resulting molten alloy was thereafter cooled in a water-cooled copper crucible. Subsequently, the Ti-Ta alloy ingot was subject to hot forging at 700°C, and thereafter subject to hot rolling at 700°C. Nevertheless, due to an unmelted residue of Ta material, the Ti-Ta alloy ingot cracked during the forging and rolling processes, and could not be processed into a target material.
As a result of analyzing this material, the composition varied within a range of 0.1 to 0.5 at%, the relative density could not be measured, the oxygen content was 350 wtppm (variation: 20%), and the Vickers hardness was 230 Hv (variation: 25%).

(Comparative Example 2)

A Ti raw material (purity of 4N or higher) and a Ta raw material (purity of 4N or higher) both having an equal side length of 60 mm and a thickness of 10 mm were prepared, and these materials were weighed to attain a Ti content of 90 at% and a Ta content of 10 at%. The Ti material was foremost placed in a melting furnace, and the Ta material was set in a batch charger for supplementary addition at once. Subsequently, vacuum skull melting was performed at a power output that the Ti material would melt and, after confirming that the Ti raw material has melted, the square Ta material was added at once. Subsequently, the Ti-Ta alloy ingot was subject to hot forging at 1000°C, and thereafter subject to hot rolling at 1000°C. Nevertheless, an unmelted residue of Ta material was observed, the Ti-Ta alloy ingot cracked slightly during the forging process or the rolling process.
As a result of analyzing this material, the composition varied within a range of 5 to 60 at%, the relative density could not be measured, the oxygen content was 250 wtppm (variation: 28%), and the Vickers hardness was 230 Hv (variation: 35%).

(Comparative Example 3)

A Ti raw material (purity of 4N or higher) and a Ta raw material (purity of 4N or higher) both having an equal side length of 30 mm and a thickness of 2 mm were prepared, and these materials were weighed to attain a Ti content of 70 at% and a Ta content of 30 at%. The Ti material was foremost placed in a melting furnace, and the Ta material was set in a batch charger for supplementary addition at once. Subsequently, vacuum skull melting was performed at a power output that the Ti material would melt and, after confirming that the Ti raw material has melted, the square Ta material was added at once. Subsequently, vacuum skull melting was further performed at a power output that the Ta material would melt, but the dispersion of the Ti material was severe and the amount of Ti was reduced, and the composition of this Comparative Example deviated from the prescribed composition.
As a result of analyzing this material, the composition varied within a range of 10 to 85 at%, the relative density could not be measured, the oxygen content was 200 wtppm (variation: 35%), and the Vickers hardness was 350 Hv (variation: 35%).

(Comparative Example 4)

A Ti powder and a Ta powder were prepared to attain an atomic composition ratio of 70:30, these powders were mixed, and thereafter sintered via vacuum hot press by being held for 2 hours at a temperature of 1300°C. The obtained Ti-Ta alloy sintered compact was thereafter machined via cutting and polishing to obtain the intended surface texture.
The oxygen content, relative density, Vickers hardness, and surface roughness of the sputtering target obtained with the foregoing processes were examined. Consequently, the oxygen content was 1300 wtppm (variation: 25%), the relative density was 95%, the Vickers hardness was 480 Hv (variation: 26%), and the surface roughness Ra was 1.5 μm.

The thus obtained target was mounted in sputtering equipment to perform sputtering. Note that the sputtering conditions were the same as Example 1. The number of particles having a size of 0.1 $\mu$m or larger that adhered to the substrate was 2500 particles. Moreover, as a result of subjecting the formed film to a heat test (heating at 700°C), peeling was observed.

(Comparative Example 5)

A Ti raw material and a Ta raw material were prepared to attain an atomic composition ratio of 90:10, these powders were powderized via atomization treatment, and thereafter sintered via vacuum hot press by being held for 2 hours at a temperature of 1300°C. The obtained Ti-Ta alloy sintered compact was thereafter machined via cutting and polishing to obtain the intended surface texture.

The oxygen content, relative density, Vickers hardness, and surface roughness of the sputtering target obtained with the foregoing processes were examined. Consequently, the oxygen content was 1000 wtppm (variation: 15%), the relative density was 97%, the Vickers hardness was 410 Hv (variation 10%), and the surface roughness Ra was 1.2 $\mu$m.

The thus obtained target was mounted in sputtering equipment to perform sputtering. Note that the sputtering conditions were the same as Example 1. The number of particles having a size of 0.1 $\mu$m or larger that adhered to the substrate was 550 particles. Moreover, as a result of subjecting the formed film to a heat test (heating at 700°C), peeling was observed.

The foregoing results are shown in Table 1.

[Table 1]

| | Intended composition | Production method | Form and method of adding Ta raw material | Condition of target | Ta composition range (at%) | Oxygen content (wtppm) | Oxygen variation (%) | Vickers hardness (Hv) | Hardness variation (%) | Relative density (%) | Surface roughness (μm) | Number of particles (0.1μm or larger) | Heat test result |
|---|---|---|---|---|---|---|---|---|---|---|---|---|---|
| Example 1 | Ti-0.1at%Ta | Melting/ Casting | Ribbon-shaped Ta was added at once | Favorable | 0.09~0.11 | 350 | 18 | 150 | 10 | 100 | 0.4 | 3 | No peeling, etc. |
| Example 2 | Ti-2at% Ta | Melting/ Casting | Ribbon-shaped Ta was added at once | Favorable | 1.9~2.1 | 320 | 19 | 170 | 12 | 100 | 0.5 | 3 | No peeling, etc. |
| Example 3 | Ti-3at% Ta | Melting/ Casting | Ribbon-shaped Ta was added in 10 batches | Favorable | 2.8~3.0 | 310 | 15 | 180 | 10 | 100 | 0.5 | 3 | No peeling, etc. |
| Example 4 | Ti-10at%Ta | Melting/ Casting | Ribbon-shaped Ta was added in 10 batches | Favorable | 9.8~10.2 | 250 | 13 | 230 | 8 | 100 | 0.6 | 8 | No peeling, etc. |
| Example 5 | Ti-20at%Ta | Melting/ Casting | Ribbon-shaped Ta was added in 10 batches | Favorable | 19.9~20.1 | 190 | 8 | 280 | 9 | 100 | 0.6 | 5 | No peeling, etc. |
| Example 6 | Ti-30at% Ta | Melting/ Casting | Ribbon-shaped Ta was added in 10 batches | Favorable | 29.5~30.1 | 150 | 5 | 380 | 6 | 100 | 0.8 | 8 | No peeling, etc. |

| | Intended composition | Production method | Form and method of adding Ta raw material | Condition of target | Ta composition range (at%) | Oxygen content (wtppm) | Oxygen variation (%) | Vickers hardness (Hv) | Hardness variation (%) | Relative density (%) | Surface roughness ($\mu$m) | Number of particles (0.1$\mu$m or larger) | Heat test result |
|---|---|---|---|---|---|---|---|---|---|---|---|---|---|
| Comparative Example 1 | Ti-0.1at%Ta | Melting/ Casting | Square Ta was added at once | Unmelted Ta residue, rolling was impossible | 0.1-0.5 | 350 | 20 | 230 | 25 | - | - | - | - |
| Comparative Example 2 | Ti-10at%Ta | Melting/ Casting | Square Ta was added at once | Unmelted Ta residue, slight crack during plastic working | 5~60 | 250 | 28 | 230 | 35 | - | - | - | - |
| Comparative Example 3 | Ti-30at%Ta | Melting/ Casting | Square Ta was added at once | Compositional deviation after melting | 10~85 | 200 | 35 | 350 | 35 | - | - | - | - |
| Comparative Example 4 | Ti-30at%Ta | Powder metallurgy | Mixed powder | Processing resistant | 29.8~30.1 | 1300 | 25 | 480 | 26 | 95 | 1.5 | 2500 | Peeling |
| Comparative Example 5 | Ti-10at%Ta | Powder metallurgy | Alloy atomized powder | Processing resistant | 9.9~10.1 | 1000 | 15 | 410 | 10 | 97 | 1.2 | 550 | Peeling |

INDUSTRIAL APPLICABILITY

The present invention has a favorable surface texture with a low oxygen content and is readily processable due to its low hardness, and therefore yields a superior effect of being able to suppress the generation of particles during sputtering. The present invention is effective as a Ti-Ta alloy sputtering target suitable for forming thin films for use in the interconnection of elements of a semiconductor integrated circuit.

**Claims**

1.   A Ti-Ta alloy sputtering target containing 0.1 to 30 at% of Ta, and remainder being Ti and unavoidable impurities, wherein the Ti-Ta alloy sputtering target has an oxygen content of 400 wtppm or less.

2.   The Ti-Ta alloy sputtering target according to claim 1, wherein a variation in the oxygen content is within 20%.

3.   The Ti-Ta alloy sputtering target according to claim 1 or claim 2, wherein the Ti-Ta alloy sputtering target has a Vickers hardness of 400 Hv or less.

4.   The Ti-Ta alloy sputtering target according to claim 3, wherein a variation in the Vickers hardness is within 10%.

5.   The Ti-Ta alloy sputtering target according to any one of claims 1 to 4, wherein the Ti-Ta alloy sputtering target has a surface roughness Ra of 1.0 $\mu$m or less.

6.   The Ti-Ta alloy sputtering target according to any one of claims 1 to 5, wherein the Ti-Ta alloy sputtering target has a purity of 4N or higher.

7.   The Ti-Ta alloy sputtering target according to any one of claims 1 to 6, wherein the Ti-Ta alloy sputtering target has a relative density of 99.9% or higher.

8.   A method of producing a Ti-Ta alloy sputtering target, the method comprising:

  preparing a Ti material having a thickness of 1 mm or more and 5 mm or less and an equal side length of 10 mm or more and 50 mm or less, and a Ta material having a thickness of 0.5 mm or more and 2 mm or less and a width of 2 mm or more and 50 mm or less;
  placing the Ti material in a vacuum melting furnace;
  after being melted, adding the Ta material thereto in order to alloy Ti-Ta;
  casting a resulting molten alloy in a water-cooled copper crucible to prepare an ingot; and
  subjecting an obtained Ti-Ta alloy ingot to plastic working to form a target shape.

9.   The method of producing a Ti-Ta alloy sputtering target according to claim 8, comprising: placing the Ti material in the vacuum melting furnace; and after being melted, adding the Ta material thereto in multiple batches.

[Fig. 1]

[Fig. 2]

## INTERNATIONAL SEARCH REPORT

| | International application No. |
|---|---|
| | PCT/JP2017/011695 |

**A. CLASSIFICATION OF SUBJECT MATTER**
*C23C14/34*(2006.01)i, *C22C14/00*(2006.01)i, *C22C27/02*(2006.01)i

According to International Patent Classification (IPC) or to both national classification and IPC

**B. FIELDS SEARCHED**

Minimum documentation searched (classification system followed by classification symbols)
C23C14/34, C22C14/00, C22C27/02

Documentation searched other than minimum documentation to the extent that such documents are included in the fields searched
Jitsuyo Shinan Koho          1922–1996    Jitsuyo Shinan Toroku Koho    1996–2017
Kokai Jitsuyo Shinan Koho    1971–2017    Toroku Jitsuyo Shinan Koho    1994–2017

Electronic data base consulted during the international search (name of data base and, where practicable, search terms used)
JSTPlus/JST7580/JSTChina(JDreamIII)

**C. DOCUMENTS CONSIDERED TO BE RELEVANT**

| Category* | Citation of document, with indication, where appropriate, of the relevant passages | Relevant to claim No. |
|---|---|---|
| A | WO 2012/014921 A1  (JX Nippon Mining & Metals Corp.),<br>02 February 2012 (02.02.2012),<br>claims 4, 8<br>& US 2013/0112556 A1<br>claims 4, 8, 9<br>& EP 2599892 A1          & CN 103025914 A | 1–9 |
| A | JP 2015-42787 A  (JX Nippon Mining & Metals Corp.),<br>05 March 2015 (05.03.2015),<br>claim 1<br>& WO 2012/008334 A1 | 1–9 |

☒ Further documents are listed in the continuation of Box C.       ☐ See patent family annex.

| * | Special categories of cited documents: |
|---|---|
| "A" | document defining the general state of the art which is not considered    to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| | |
|---|---|
| "T" | later document published after the international filing date or priority date and not in conflict with the application but cited to understand the principle or theory underlying the invention |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| 31 May 2017 (31.05.17) | 13 June 2017 (13.06.17) |

| Name and mailing address of the ISA/<br>Japan Patent Office<br>3-4-3,Kasumigaseki,Chiyoda-ku,<br>Tokyo 100-8915,Japan | Authorized officer |
|---|---|
| | Telephone No. |

Form PCT/ISA/210 (second sheet) (January 2015)

**INTERNATIONAL SEARCH REPORT**

International application No.

PCT/JP2017/011695

C (Continuation).   DOCUMENTS CONSIDERED TO BE RELEVANT

| Category* | Citation of document, with indication, where appropriate, of the relevant passages | Relevant to claim No. |
|---|---|---|
| A | JP 3-197640 A  (Toshiba Corp.),<br>29 August 1991 (29.08.1991),<br>claims 1, 4<br>(Family: none) | 1-9 |
| A | JP 3-130339 A  (Toshiba Corp.),<br>04 June 1991 (04.06.1991),<br>claims 1, 10<br>& US 5204057 A1<br>claims 1, 5<br>& EP 408383 A1 | 1-9 |
| A | JP 5701879 B2  (JX Nippon Mining & Metals<br>Corp.),<br>15 April 2015 (15.04.2015),<br>claims 1, 5<br>(Family: none) | 1-9 |
| A | JP 2010-123586 A  (NEC Electronics Corp.),<br>03 June 2010 (03.06.2010),<br>claims 1, 7<br>& US 2010/0123249 A1<br>claims 1, 7<br>& CN 101740547 A | 1-9 |

Form PCT/ISA/210 (continuation of second sheet) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2001110751 A
- JP 2008098284 A
- JP 2010123586 A
- JP H01290766 A
- JP 2004506814 A
- JP 5701879 B